Europäisches Patentamt

European Patent Office

Office européen des brevets

(11) Veröffentlichungsnummer: **0 222 261**
B1

# EUROPÄISCHE PATENTSCHRIFT

(45) Veröffentlichungstag der Patentschrift:
21.02.90

(51) Int. Cl.⁴: **H02M 1/14**

(21) Anmeldenummer: 86115041.5

(22) Anmeldetag: 29.10.86

(54) **Hochpass einer Filteranordnung für ein mit Umrichtern verbundenes Drehstromnetz.**

(30) Priorität: 11.11.85 DE 3539950

(43) Veröffentlichungstag der Anmeldung:
20.05.87 Patentblatt 87/21

(45) Bekanntmachung des Hinweises auf die Patenterteilung:
21.02.90 Patentblatt 90/8

(84) Benannte Vertragsstaaten:
DE GB

(56) Entgegenhaltungen:
EP-A- 0 141 230
US-A- 3 038 134
US-A- 3 935 551

(73) Patentinhaber: Siemens Aktiengesellschaft,
Witteisbacherplatz 2, D-8000 München 2(DE)

(72) Erfinder: Schultz, Walter, Dipl.-Ing., Mühlenstrasse 11,
D-8524 Kleinsendelbach(DE)
Erfinder: Krüger, Kurt, Dipl.-ing., Killingerstrasse 78,
D-8520 Erlangen(DE)
Erfinder: Touchy, Ute, Zenkerstrasse 35,
D-8520 Erlangen(DE)

## Beschreibung

Die Erfindung betrifft einen Hochpaß einer Filteranordnung für ein mit Umrichtern verbundenes Drehstromnetz, bestehend aus R-, L- und C-Gliedern für zwei Harmonische.

Es ist aus der IEEE Transactions on Power Apparatus and Systems, Vol. PAS - 102, No. 9, Sept. 1983, insbesondere Seiten 3209, ein Hochpaß für zwei charakteristische Harmonische 11/13.er Ordnung bekannt.

Die aus der US-A 3 935 551 vorbekannte Filteranordnung für HGÜ-Leitungen besteht aus zwei getrennten Hochpassen je Phase der HGÜ-Leitung, wobei der eine Hochpaß eine Resonanzfrequenz gleich der 11. Harmonischen und der andere eine höhere Resonanzfrequenz aufweist. Gemäß der Problemstellung ist diese Filteranordnung für zwölfpulsige Stromrichterschaltung ausgelegt.

In der vorbekannten US-A 3 038 134 ist eine Filteranordnung für ein mit einem Gleichstromnetz verbundenen Wechselstromnetz beschrieben, die aus einer Parallelschaltung von zwei einzelnen getrennt wirkenden Filtern besteht, wobei das eine Filter für die zwei niedrigsten Harmonischen jeweils ein Minimum aufweisen soll und das andere Filter eine niedrige Impedanz für die übrigen Harmonischen aufweist. Dabei ist eine Bedämpfung von Frequenzpaaren, insbesondere der fünften und siebten Harmonischen, gewünscht, die sich aus der Formel $f = (k \cdot p \pm 1) \cdot f_1$ ergeben. Bei einer solchen Filteranordnung werden immer zwei leistungsstarke Koppelkondensatoren zur Ankopplung an das zu kompensierende Netz benötigt.

Für andere als charakteristische Harmonische benachbarter Ordnung sind zur Filterung von Oberschwingungsströmen auf hoher Spannungsebene oftmals zusätzlich abgestimmte Filterkreise, bzw. bevorzugt einzelne Hochpässe erforderlich, die zur Erfüllung der Blindleistungsbedingungen aber in der notwendigen Zeit oftmals entweder nicht wirtschaftlich betrieben oder gebaut werden können, da die Summenblindleistungsbedingung für das Netz nicht erfüllt werden kann.

Darüber hinaus tritt im Bereich von Harmonischen niedriger Ordnungszahlen von 2. bis etwa 5. Ordnung zwischen dem Netz und der gesamten Filteranordnung eine Parallelresonanzstelle auf, die mit einem entsprechenden Oberschwingungsstrom eine unzulässig hohe Einzelverzerrung in der Spannung ergeben kann. Es können aber unzulässig hohe Überspannungen auftreten, wenn die zugehörige Filterfrequenz mit der Frequenz einer Oberschwingung zusammenfällt. Mit Filtern niedriger Ordnungszahl und kleiner Leistung kann die Oberschwingungsspannung auf zulässige Werte begrenzt werden. Zum Schutz gegen zusätzliche Beanspruchungen aus dem Netz, beispielsweise Sättigungs- und Resonanzerscheinungen beim Einschalten von Transformatoren, müssen die Filter überdimensioniert und gegebenenfalls zusätzlich verlusterhöhend bedämpft werden. Von Nachteil ist ferner, daß - wie schon erwähnt - die benötigte Kompensationsleistung für Filterkreise niedriger Ordnung für die Filterung der charakteristischen Oberschwingungen nicht zur Verfügung steht.

Der Erfindung liegt die Aufgabe zugrunde, Aufwand und Verluste für die erforderlichen Hochpässe zu verringern und auf gesonderte Filter für die Bedämpfung von Parallelresonanzen verzichten zu können.

Die Lösung der Aufgabe gelingt auf sichere Weise durch die kennzeichnenden Merkmale des Patentanspruchs 1.

Bei Umrichteranlagen mit Filterkreisen in Netzen mit Tonfrequenz-Rundsteueranlagen ist oft der Einsatz zusätzlicher gesonderter Frequenzsperren für die Tonfrequenzen notwendig.

Zur Vermeidung solcher Frequenzsperren können die Filterkreise zumindest teilweise als Doppel-Hochpaß, unter Umständen bei Fortfall von Dämpfungswiderständen, gemäß den kennzeichnenden Merkmalen des Patentanspruchs 2 ausgeführt sein, wobei vorzugsweise die Parallelresonanzstelle des Doppel-Hochpasses möglichst nahe zur Frequenz der betreffenden Tonfrequenz-Rundsteueranlage gelegt wird.

In der Zeichnung sind schematisch zwei Ausführungsbeispiele einer Hochpaß-Filteranordnung gezeigt, wobei in

Fig. 1 ein Hochpaß für ein Drehstromnetz ohne Rundsteueranordnung gezeigt ist, wobei der gestrichelt eingezeichnete Reihenwiderstand bei einem Netz mit Rundsteuerbetrieb entfallen kann und für beide Fälle jeweils unterschiedlich bemessene Schaltungselemente vorgesehen sind, die nach den in

Fig. 2 schematisch angedeuteten Betriebsbedingungen jeweils bemessen werden müssen, in der der Zusammenhang zwischen der jeweiligen Kreisfrequenz $\omega$ und dem Scheinwiderstand Z in logarithmischer Darstellung gezeigt ist.

Die aufzubringende Blindleistung Q für die Grundschwingung entspricht

$Q \sim U^2 \cdot \omega \cdot C_R$ [1] worin U die Netzspannung und $\omega$ die Netzkreisfrequenz bedeuten

Für hohe Frequenzen ist die resultierende Kapazität C wirksam

$$1/C = \frac{1}{C_R} + \frac{1}{C_P} \quad [2] \text{ und somit ist}$$

$$C = \frac{C_R \cdot C_P}{C_R + C_P} \quad [3]$$

Der Scheinwiderstand Z ergibt sich als Minimalwert zu

$$Z_{min} = \frac{S}{G} \quad [4] \text{ mit}$$

S als Schwingungswiderstand und
G als Güte des Schwingkreises.

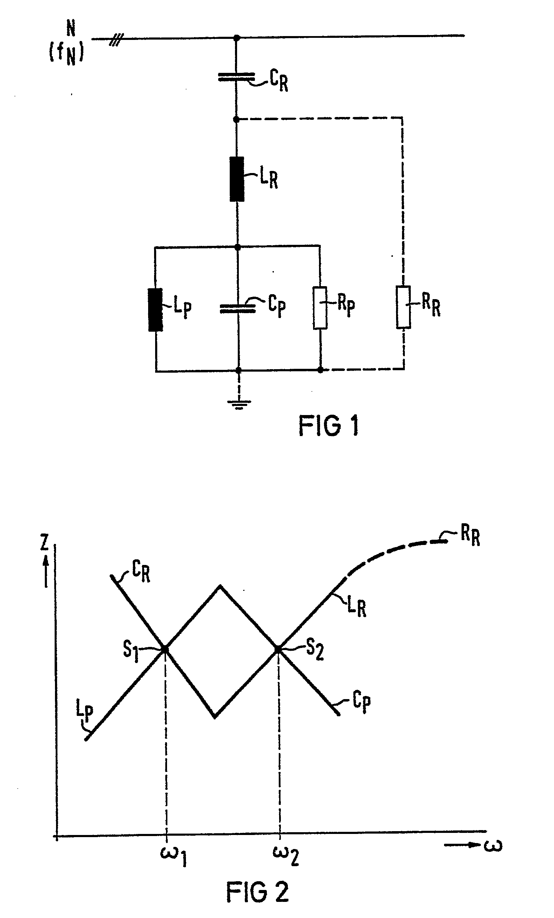

Durch den in Fig. 1 insgesamt dargestellten, an ein Netz N angeschlossenen Hochpaß mit dem Reihenkondensator $C_R$, der Reihendrossel $L_R$ und dem zwischen beiden angeschlossenen, bei Hochspannung geerdeten, bei Mittelspannung freien Reihenwiderstand $R_R$, der durch die entsprechend geschalteten Parallelglieder $L_P$, $C_P$, $R_P$ ergänzt ist, ergeben sich vereinfacht für die durch die Schaltungselemente $C_R$ und $L_P$ einerseits sowie die Schaltungselemente $C_P$ und $L_R$ andererseits bestimmten Teilkennlinien als Schnittpunkte zwei Schwingwiderstände

$$S_1 = \frac{1}{\omega_1 C_R} - \omega_1 L_R \quad [5] \quad \text{und}$$

$$S_2 = \omega_2 L_R - \frac{1}{\omega_2 C_R} \quad [6]$$

Der Reihenwiderstand $R_R$ senkt den Anstieg des Scheinwiderstandes in Abhänigkeit von der Kreisfrequenz für höhere Frequenzen ab. Die Schaltung ist so bemessen, daß im kritischen Oberschwingungsbereich höchstens eine unschädliche geringe Resonanzüberhöhung auftreten kann, was durch die entsprechende Abstimmung der beiden Resonanzfrequenzen und Güten erreicht wird. Die Berechnung und Auslegung kann vorteilhafterweise mittels eines entsprechenden Digital-Programms vorgenommen werden.

Der Parallelwiderstand $R_P$ dämpft, wobei er für andere als die Resonanzkreisfrequenz $\omega_1$, $\omega_2$, insbesondere für die Netzfrequenz $f_N$, verlustarm arbeitet.

Bei Netzbetrieb mit Rundsteuerung kann der Reihenwiderstand $R_R$ entfallen. Die Netzparallelresonanz für die Rundsteuerfrequenz $f_{Rundst} \neq f_N$ wird hierbei gedämpft ohne nachteilige Beeinflußung des übrigen Betriebes.

## Patentansprüche

1) Hochpaß einer Filteranordnung für ein mit Umrichtern verbundenes Drehstromnetz, bestehend aus R-, L- und C-Gliedern für zwei Harmonischen, **dadurch gekennzeichnet**, daß ein C-Glied ($C_R$), ein L-Glied ($L_R$) sowie ein Parallelpfad aus je einem R-, L- und C-Glied ($L_P$, $C_P$, $R_P$) in Reihe geschaltet sind und zur Reihenschaltung des L-Gliedes ($L_R$) mit dem Parallelpfad ($L_P$, $C_P$, $R_P$) ein zusätzliches R-Glied ($R_R$) parallelgeschaltet ist, und diese Anordnung einen auf zwei beliebige unterschiedliche Frequenzen abgestimmten Doppel-Hochpaß bilden, der mit seinen beiden Resonanzfrequenzen und Güten so abgestimmt ist, daß durch das R-Glied ($R_P$) im Parallelpfad im kritischen Oberschwingungsbereich niedriger Ordnungszahlen höchstens nur eine geringe Resonanzüberhöhung zwischen Netz (N) und Filteranordnung auftritt, wobei das R-Glied ($R_P$) im Parallelpfad für die übrigen Frequenzen verlustarm ist.

2) Hochpaß einer Filteranordnung nach Anspruch 1, **dadurch gekennzeichnet**, daß bei an das Netz angeschlossenen Tonfrequenz-Rundsteueranlagen der bevorzugt auf ein oder zwei charakteristische Harmonische abgestimmte Doppel-Hochpaß unter Fortfall des zusätzlichen R-Gliedes so in seiner Parallelresonanz abgestimmt ist, daß eine Absaugung der Tonfrequenz unterbunden, aber Oberschwingungen der Umrichter abgeleitet werden.

## Claims

1. High-pass filter of a filter arrangement for a three phase system connected to converters, consisting of R-, L- and C-elements for two harmonics, characterised in that a C-element ($C_R$), an L-element (L$_R$) and a parallel circuit consisting of respective R-, L- and C-elements (L$_p$, C$_p$, R$_p$) are connected in series and an additional R-element (R$_R$) is connected in parallel with the series-connected L-element (L$_R$) and the parallel circuit (L$_p$, C$_p$, R$_p$), and this arrangement constitutes a double high-pass filter tuned to two different desired frequencies and whose two resonant frequencies and qualities are so matched that owing to the R-element (R$_p$) in the parallel circuit, in the critical range of low ordinal number harmonics only at most a small resonance sharpness occurs between the supply system (N) and the filter arrangement, the R-element (R$_p$) in the parallel circuit being low-loss for the remaining frequencies.

2. High-pass filter of a filter arrangement according to claim 1, characterised in that when audio frequency ripple control systems are connected to the supply system, the double high-pass filter preferably tuned to one or two characteristic harmonics and with the additional R-element omitted, is tuned in its parallel resonance such that audio-frequency suppression does not occur, but harmonics of the converters are filtered.

## Revendications

1. Filtre passe-haut d'un dispositif de filtrage pour un réseau à courant alternatif raccordé à un convertisseur statique et constitué par des circuits R, L et C pour deux harmoniques, caractérisé par le fait qu'un circuit C (C$_R$), un circuit L (L$_R$) ainsi qu'une voie parallèle formée par des circuits respectifs R, L et C (L$_p$, C$_p$, R$_p$), sont branchés en série et qu'un circuit R supplémentaire (R$_R$) est branché en parallèle avec le montage série formé du circuit L (L$_R$) et de la voie parallèle (L$_p$, C$_p$, R$_p$), que ce dispositif forme un filtre passe-haut double, qui est réglé sur deux fréquences quelconques différentes et dont les deux fréquences de résonance et les facteurs de qualité sont accordés de telle sorte qu'au maximum seule une faible amplification de résonance apparaît entre le réseau (N) et le dispositif de filtrage sous l'effet de la présence du circuit R (R$_p$) situé dans la voie parallèle, dans la plage critique d'harmoniques possédant des numéros d'ordre faibles, le circuit R (R$_p$) situé dans la voie parallèle présentant de faibles pertes pour les autres fréquences.

2. Filtre passe-haut d'un dispositif de filtrage suivant la revendication 1, caractérisé par le fait que, dans le cas d'installations de télécommande centralisée à fréquences vocales, raccordées au réseau, le filtre passe-haut double, réglé de préférence sur un ou deux harmoniques caractéristiques, possède une résonance parallèle accordée, moyennant la suppression du circuit R supplémentaire, de manière à éliminer l'aspiration de la fréquence vocale, mais à tirer des harmoniques des convertisseurs statiques.

EP 0 222 261 B1

FIG 1

FIG 2